# EUROPEAN PATENT SPECIFICATION

(11) **EP 1 599 080 B1**
(45) Date of publication and mention of the grant of the patent: **22.07.2009**
(21) Application number: 05104170.5
(22) Date of filing: 18.05.2005
(51) Int. Cl.: F24H 9/20, H05K 7/20, H05B 1/02, H05B 3/42

(54) **Thermal bridge for heat dissipation from control circuits of fluid radiant elements**
Thermische Brücke zur Wärmeableitung von einem Schaltkreis für Flüssigkeitheizelemente
Pont thermique pour dissiper la chaleur d' un circuit de commande d' éléments radiants à fluide

(30) Priority: 18.05.2004 IT VI20040120
(43) Date of publication of application: 23.11.2005
(73) Proprietor: Lacroix Electronique SRL, 31056 Roncade (TV) (IT)
(72) Inventor: Marchetti, Corrado, 31052 VARAGO di MASERADA sul PIAVE (TV) (IT)
(74) Representative: Bonini, Ercole

(56) References cited:
- EP-A- 0 317 435
- EP-A- 1 278 400
- WO-A-03/100326
- DE-A1- 19 913 141

## Description

The present invention relates to a fluid radiant element comprising a thermal bridge for dissipation of heat produced by solid state switches, generally TRIAC or SCR, which are present in control circuits of said fluid radiant elements heated by electric heaters.

More specifically, the thermal bridge is associated to control circuits of radiators for heating rooms and/or napkins and towels.

It is well-known that in the radiant elements of the above-mentioned kind, the carrier fluid is heated by proper heaters comprising a tubular body inserted in the body of the radiant element, having inside an electric resistance which is fed by the supply mains.

The tubular body has at one end a tubular fixing sleeve to the body of the radiant element, through which the leads for connecting the electric resistance to the supply mains are passing.

The control circuit regulating the temperature and the operation mode of the radiant element is well-known per se and comprises a solid state switch consisting of a bi-directional thyristor (TRIAC or SCR) and electronic control means suited to regulate tripping and closure of the switch.

The control circuit is enclosed inside a case which is associated to the body of the radiant element and from which the heat produced by the switch during the operation must be properly and efficiently dissipated.

To this purpose, according to the prior art embodiments, the case is kept slightly open to let an air-flow pass for cooling the solid state switch.

Therefore, cooling occurs by natural ventilation and has the limitation which is generally insufficient to obtain the expected cooling.

Another drawback consists in that the accident prevention rules are not respected because said rules state that the electric apparatus must be closed during the operation.

Moreover, water seepage or dust infiltration in the case could occur.

It is also known to use heat sinks that are directly applied to the case containing the control circuit with the relevant solid state switch.

EP 0 317 415 A1 discloses a heating element with an electronic control for heating a liquid contained in a vessel with a liquid-tight wall in which a solid state switch is coupled with a mounting flange connected to said heating element.

Even the application of said heat sinks does not solve satisfactorily the problem of heat dissipation and makes the manufacture more complex.

On the other hand, it is generally known that if during operation the heat produced by the solid state switch causes temperature to increase inside the case over 100°C, the proper operation of the electronic components is jeopardized and, moreover, said switch is irreparably damaged.

The present invention aims at overcoming said drawbacks.

To this purpose, it was observed that if the radiant element operates in a correct way, on the fixing connection of the heater to the body of the radiant element the temperature does not exceed a value between 70 and 80°C approximately corresponding to the outer temperature of said radiant element.

On the other hand, the heat dissipated by the solid state switch does not exceed, in the most critical cases, the value of 10 watts constituting a power value absolutely negligible in comparison with the power of the resistance equipping the heater that generally has values between 500 and 2000 watts.

Therefore, the heat produced by the solid state switch is insufficient to increase the temperature of the fixing sleeve of the heater to the radiant element in view of the mass of said radiant element.

Therefore, if the body of the solid state switch is physically connected to the tubular sleeve, the latter operates as a heat sink and allows to keep the switch temperature within values between 90 and 100°C, therefore below the critical value.

The present invention intends to avoid the foregoing drawbacks making use of the above-mentioned considerations.

More particularly, a first object of the invention is to provide a physical connection between the solid state switch of a control circuit applicable to a fluid radiant element and the thermal dispersion means.

Another object is to provide a connection according to the invention making easier and more efficient the dissipation of heat produced by the switch in comparison with the prior art dissipation systems.

A further object is that the connection can be carried out inside the case containing the control circuit.

A last but not least object is that the thermal bridge of the invention be easy to be manufactured and assembled.

The foregoing objects are attained through a thermal bridge for transmission of heat produced by solid state switches of control circuits applicable to fluid radiant elements, according to the main claim.,

Moreover, fastening means for the switch inside the relevant housing are provided.

Advantageously, the use of the thermal bridge of the invention allows a greater constructional simplification and a better thermal dispersion of the heat produced by the solid state switch.

Still advantageously, the use of said thermal bridge allows to keep the case containing the control circuit sealed, to the advantage of the accident prevention and operation safety.

Said objects and advantages will be better understood with the aid of the following description of a preferred embodiment of the invention, which is given as an illustrative and non-limiting example and described with reference to the accompanying sheets of drawings in which:
- Figure 1 is an exploded isometric view of a radiant element using the thermal bridge of the invention;
- Figure 2 is a front assembled view of the radiant element of Figure 1;
- Figure 3 is a detail of the radiant element of figures 1 and 2;
- Figure 4 is an enlarged detail of Figure 3;
- Figure 5 is an exploded isometric view of a detail of figures 1 and 2 where the thermal bridge of the invention is illustrated; and
- Figure 6 shows the assembled detail of Figure 5 from a different point of view.

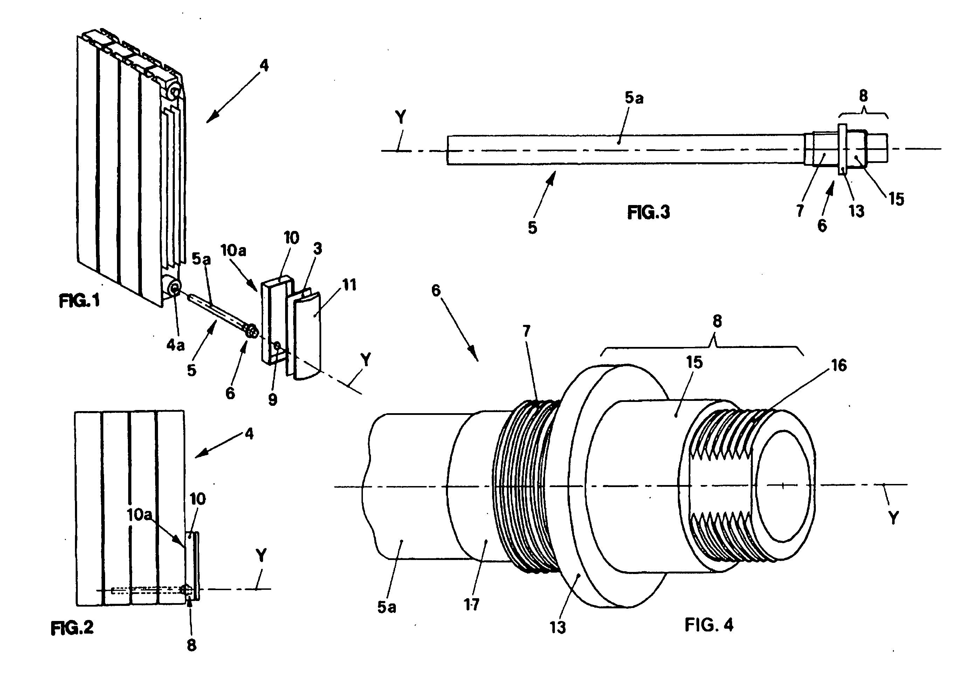

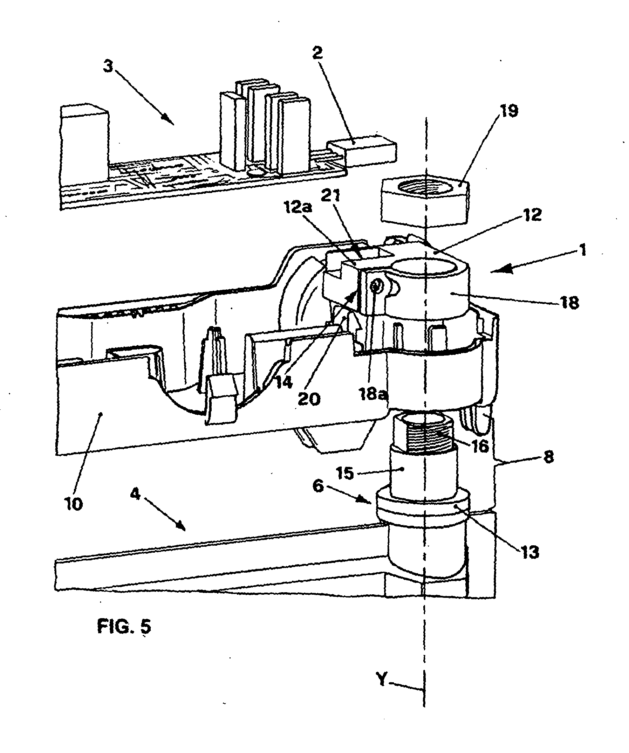

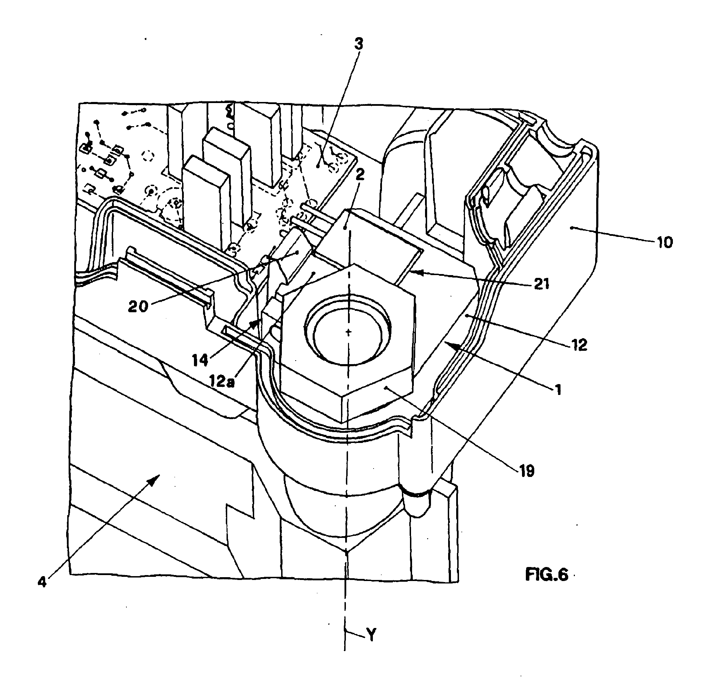

The thermal bridge of the invention, generally indicated with numeral **1** in figures 5 and 6, is used for transmission of the heat produced during the operation of the solid state switch **2** of a control circuit, generally indicated with numeral **3,** which is applied to fluid radiant elements, one of which is of the kind shown in two different views of figures 1 and 2 where it is generally indicated with numeral **4**.

To the radiant element **4** a heater **5** is applied, shown also in Figure 3, which is formed by a tubular body **5a** inserted in a housing **4a** made in the body of the radiant element **4,** and internally provided with an electric resistance not shown in the drawing, which is connected to the power supply mains.

The tubular body **5** is fixed to the radiant element **4** through a tubular sleeve **6** that can be seen in detail and in isometric view in Figure 4, which is provided with fastening means to the radiant element, which consist of a thread 7 which is coupled to a corresponding opposite thread made in the seat **4a.**

The end portion **8** of the tubular sleeve **6** projecting from the housing **4a** is arranged passing through a hole **9** of a case **10** which, as shown in figures 1 and 2, is fixed to the radiant element **4** and is closed by a lid **11.**

Inside the case **10** said control circuit **3** with the relevant solid state switch **2** is arranged.

It has to be pointed out that the term "solid state switch" means a bi-directional thyristor commonly referred to as TRIAC or SCR.

According to the invention, the thermal bridge **1** consists of a collector body **12** made of thermally conductive material and arranged inside said case **10** where it is in contact with said at least one solid state switch **2** and said end portion **8** of said sleeve **6.**

One can see, more particularly in Figure 4, that the end portion **8** of the tubular sleeve **6** is separated from the fastening means **7** of said sleeve in the corresponding seat **4a** by an annular shoulder **13** which is arranged externally close to the bottom **10a** of the case **10** when the latter is fixed to the radiant body 4.

In this condition, the end portion **8** of the tubular body **6** is inserted into the hole **9.**

The coupling manner is clearly visible also in Figure 5 where the case **10** and the sleeve **6** are shown in an exploded view with the end portion **8** of the sleeve arranged co-axially along the longitudinal axis **Y** in the hole **9,** not shown in the drawing, made in the case 10.

More particularly, with reference to figures 5 and 6, in the collector body **12** connection means to the end portion **8** of the tubular sleeve **6** and housing means suited to receive the solid state switch **2** are defined.

More particularly, the connecting means consist of a tightening clamp 14, which is circumferentially coupled outside the cylindrical body **15** of the tubular sleeve **6,** and of an end thread **16** substantially forming the outer side of said tubular body **6.**

In figures 3 and 4 one can see that the annular shoulder **13** separates the cylindrical body 15 from the thread 7 coupling to the radiant body 4 and ending with a coupling fitting **17** to the tubular body **5a.**

Again with reference to the tightening clamp 14 one can see that it consist of a slit ring **18** in the form of C, provided at the ends with a couple of opposite co-axial holes **18a** receiving a screw, not shown in the drawing, tightening the ring **18** outside the cylindrical body **15** after the mutual coupling.

Preferably, but not necessarily, the holes **18a** are through holes in which a self tapping screw is received.

A nut **19** coupled to the end thread **16** of the tubular element **6** is provided to keep the thermal bridge **1** constrained and avoid its axial separation along the axis **Y** after the assembly.

In order to obtain also the coupling stability against rotation around said axis **Y,** the case 10 is provided with a detent 20 which is engaged against the upper surface **12a** of the thermal bridge **1** after its coupling with the tubular element 6.

As to the housing means receiving the switch 2, they consist of a prismatic seat **21** recessed in the collector element **12** and provided with an internal profile matching the outer profile of the corresponding solid state switch **2.**

Locking of the switch 2 in the corresponding seat 21 may occur through locking means of any type, for instance screw means or spring means and according to the insulation degree to be carried out.

In operation, to assemble the thermal bridge **1** first of all the heater **5** must be inserted in the radiant body **4** and then the end portion **8** of the tubular sleeve **6** must be coupled in the hole **9** of case **10** in which the control circuit **3** was previously installed.

The ring **18** of the tightening clamp **14** is then fit with a sliding movement along the axis **Y** on the cylindrical body 15 of the tubular element 6 until the detent **20** snaps so that it is positioned on the surface **12a** of the collector **12,** as shown in Figure 6.

In this way, the detent 20 prevents the rotation of the thermal bridge around the axis **Y.**

Then, the thermal bridge **1** is axially blocked through the nut **19** and radially on the cylindrical body **15** by tightening the screw coupled in the holes **18a.**

Concomitantly with said operations, the solid state switch **2** must be arranged inside the corresponding seat **21** and then locked through the above-mentioned locking means.

Closure of the lid **11,** which is hooked to the case **10,** ends the assembling operation.

In view of the foregoing a compact structure was therefore realized in which the thermal bridge of the invention improves the dissipation of heat produced by the solid state switch through the tubular sleeve fastening the heater.

The sleeve therefore acts as a thermal collector to the mass formed by the radiant element.

The thermal exchange so obtained, according to experimental tests, results to be quite sufficient to keep the temperature of the solid state switch under the critical temperature of 100°C as previously mentioned.

In the constructional stage, many executive variations may be made to the thermal bridge of the invention, even if not described nor illustrated in the drawings which, when falling within the scope of the following claims are to be considered covered by the present patent.

## Claims

1. Fluid radiant element (4) comprising: a thermal bridge (1) for transmission of heat produced by solid state switches (2) of control circuits (3) to be applied to said fluid radiant elements (4) and,
- at least a heater (5) formed by at least a tubular body (5a) inserted in a housing (4a) made in the body of said radiant element (4) and internally provided with an electric resistance connected to a power supply;
- a tubular sleeve (6) arranged at one end of said tubular body (5a) and provided with fastening means (7) to said radiant element (4);
- a case (10) containing said control circuit (3) with said solid state switch (2), a through hole (9) being provided in said case (10), through said hole the end portion (8) of said tubular sleeve (6) being inserted projecting from said housing (4a) of said radiant element (4),
said thermal bridge (1) consisting of a collector body (12) made of thermally conductive material and in contact with said at least one solid state switch (2) and with said end portion (8) of said sleeve (6),
said collector body (12) comprising connection means (14) coupled to said end portion (8) of said tubular sleeve (6) and comprising also housing means (21) suited to receive said at least one solid state switch (2), **characterized in that**, said thermal bridge (1) is arranged inside said case (10).

2. The fluid radiant element (4) according to claim 1, **characterized in that** said connecting means comprise a tightening clamp (14) with circular section coupled outside a cylindrical body (15) of said sleeve (6) provided with an end thread (16).

3. The fluid radiant element (4) according to claim 2, **characterized in that** said cylindrical body (15) receiving said clamp (14) is arranged between an annular shoulder (13) and said end thread (16) of said tubular sleeve.

4. The fluid radiant element (4) according to claim 3, **characterized in that** a nut (19) is coupled to said end thread (16) of said tubular sleeve (6), said nut being suited to tighten said thermal bridge (1) against the bottom of said case (10) when said end portion (8) of said sleeve (6) is inserted into said case (10) and is arranged with said annular shoulder (13) externally close to the bottom (10a) of said case.

5. The fluid radiant element (4) according to claim 2, **characterized in that** said tightening clamp (14) consists of a slit ring (18) in the form of a C, provided with two opposite and mutually co-axial holes (18a) made at the ends of said C-like ring and suited to receive a closing screw to be actuated by the operator.

6. The fluid radiant element (4) according to claim 5, **characterized in that** said screw is a self tapping screw.

7. The fluid radiant element (4) according to claim 1, **characterized in that** said housing means consist of one or more prismatic seats (21) each of them being recessed in said collector body (12) and having its internal profile matching the outer profile of the corresponding solid state switch (2).

8. The fluid radiant element (4) according to claim 7, **characterized by** comprising locking means for said solid state switch (2) inside the relevant prismatic seat (21).

## Patentansprüche

1. Fluid-Strahlungsheizkörper (4), umfassend:
- eine Wärmebrücke (1) zur Übertragung von Wärme, die von Festkörperschaltern (2) von Regelkreisen (3), die auf die Fluid-Strahlungsheizkörper (4) anzuwenden sind, erzeugt wird, und
- zumindest eine Heizvorrichtung (5), die zumindest aus einem röhrenförmigen Körper (5a) gebildet ist, der in einem Gehäuse (4a), das im Körper des Strahlungsheizkörpers (4) ausgebildet ist, eingeführt ist und innen mit einem elektrischen Widerstand, der mit einer Stromversorgung verbunden ist, ausgestattet ist;
- eine röhrenförmige Hülse (6), die an einem Ende des röhrenförmigen Körpers (5a) angeordnet ist und mit Mitteln zur Befestigung (7) am Strahlungsheizkörper (4) ausgestattet ist;
- einen Kasten (10), der den Regelkreis (3) mit dem Festkörperschalter (2) enthält, wobei ein Durchgangsloch (9) im Kasten (10) ausgebildet ist und der Endabschnitt (8) der röhrenförmigen Hülse (6), der aus dem Gehäuse (4a) des Strahlungsheizkörpers (4) vorsteht, durch das Loch eingeführt ist,
wobei die Wärmebrücke (1) aus einem Kollektorkörper (12) besteht, der aus einem Wärme leitenden Material hergestellt ist und in Kontakt zum zumindest einen Festkörperschalter (2) sowie zum Endabschnitt (8) der röhrenförmigen Hülse (6) steht,
wobei der Kollektorkörper (12) Verbindungsmittel (14) umfasst, die mit dem Endabschnitt (8) der röhrenförmigen Hülse (6) gekoppelt sind, und ferner Unterbringungsmittel (21) umfasst, die dazu geeignet sind, den zumindest einen Festkörperschalter (2) aufzunehmen,
**dadurch gekennzeichnet, dass** die Wärmebrücke (1) im Inneren des Kastens (10) angeordnet ist.

2. Fluid-Strahlungsheizkörper (4) nach Anspruch 1), **dadurch gekennzeichnet, dass** die Verbindungsmittel eine Spannklemme (14) mit kreisförmigem Querschnitt umfassen, die außen an einem zylindrischen Körper (15) der Hülse (6), die mit einem Endgewinde (16) ausgestattet ist, gekoppelt ist.

3. Fluid-Strahlungsheizkörper (4) nach Anspruch 2), **dadurch gekennzeichnet, dass** der zylindrische Körper (15), der die Klemme (14) aufnimmt, zwischen einer ringförmigen Schulter (13) und dem Endgewinde (16) der röhrenförmigen Hülse enthalten ist.

4. Fluid-Strahlungsheizkörper (4) nach Anspruch 3), **dadurch gekennzeichnet, dass** eine Mutter (19) mit dem Endgewinde (16) der röhrenförmigen Hülse (6) gekoppelt ist, wobei die Mutter dazu geeignet ist, die Wärmebrücke (1) gegen den Boden des Kastens (10) hin festzuspannen, wenn der Endabschnitt (8) der Hülse (6) im Kasten (10) eingeführt ist und mit der ringförmigen Schulter (13) außen nahe zum Boden (10a) des Kastens angeordnet ist.

5. Fluid-Strahlungsheizkörper (4) nach Anspruch 2), **dadurch gekennzeichnet, dass** die Spannklemme (14) aus einem C-förmigen Spaltring (18) besteht, der mit zwei gegenüberliegenden und zueinander koaxialen Löchern (18a) ausgestattet ist, die an den Enden des C-artigen Rings ausgebildet sind und dazu geeignet sind, eine Verschlussschraube aufzunehmen, die von der Bedienungsperson zu betätigen ist.

6. Fluid-Strahlungsheizkörper (4) nach Anspruch 5), **dadurch gekennzeichnet, dass** die Schraube eine Schneidschraube ist.

7. Fluid-Strahlungsheizkörper (4) nach Anspruch 1), **dadurch gekennzeichnet, dass** das Unterbringungsmittel aus einem oder mehreren prismatischen Sitzen (21) besteht, von denen jeder im Kollektorkörper (12) vertieft ausgebildet ist und ein Innenprofil aufweist, das zum Außenprofil des entsprechenden Festkörperschalters (2) passt.

8. Fluid-Strahlungsheizkörper (4) nach Anspruch 7), **dadurch gekennzeichnet, dass** er Mittel zum Blockieren des Festkörperschalters (2) im Inneren des entsprechenden prismatischen Sitzes (21) umfasst.

## Revendications

1. Élément radiant à fluide (4) comprenant:
- un pont thermique (1) pour la transmission de chaleur produite par des interrupteurs à état solide (2) de circuits de commande (3) pouvant être appliqués auxdits éléments radiants (4) et
- au moins un réchauffeur (5) composé d'au moins un corps tubulaire (5a) inséré dans un logement (4a) réalisé dans le corps dudit élément radiant (4) et doté à l'intérieur d'une résistance électrique reliée à un reseau d'alimentation;
- un manchon tubulaire (6) positionné sur une extrémité dudit corps tubulaire (5a) et doté de moyens de fixation (7) audit élément radiant (4);
- un boîtier (10) contenant ledit circuit de commande (3) avec ledit interrupteur à état solide (2), un trou passant (9) étant présent dans ledit boîtier (10), la partie finale (8) dudit manchon tubulaire (6), étant insérée à travers ledit trou, saillant dudit logement (4a) dudit élément radiant (4),
ledit pont thermique (1) se composant d'un corps collecteur (12) réalisé en matériel thermiquement conducteur et étant en contact avec ledit au moins un interrupteur à état solide (2) et avec ladite partie finale (8) dudit manchon (6),
ledit corps collecteur (12) comprenant des moyens de raccordement (14) reliés à ladite partie finale (8) dudit manchon tubulaire (6) et comprenant également des moyens de logement (21) indiqués pour recevoir ledit au moins un interrupteur à état solide (2),
**caractérisé en ce que** ledit pont thermique (1) se trouve à l'intérieur dudit boîtier (10).

2. Élément radiant à fluide (4) selon la revendication 1), **caractérisé en ce que** lesdits moyens de raccordement comprennent un étau de serrage (14) à section circulaire relié à l'extérieur d'un corps cylindrique (15) dudit manchon (6) doté d'un filetage final (16).

3. Élément radiant à fluide (4) selon la revendication 2), **caractérisé en ce que** ledit corps cylindrique (15) recevant ledit étau (14) est positionné entre un épaulement annulaire (13) et ledit filetage final (16) dudit manchon tubulaire.

4. Élément radiant à fluide (4) selon la revendication 3), **caractérisé en ce qu'**un écrou (19) est relié audit filetage final (16) dudit manchon tubulaire (6), ledit écrou étant indiqué pour serrer ledit pont thermique (1) contre le fond dudit boîtier (10) quand ladite partie finale (8) dudit manchon (6) est insérée dans ledit boîtier (10) et est positionnée avec ledit épaulement annulaire (13) extérieurement près du fond (10a) dudit boîtier.

5. Élément radiant à fluide (4) selon la revendication 2), **caractérisé en ce que** ledit étau de serrage (14) se compose d'un anneau ouvert (18) en forme de C, doté de deux trous opposés et coaxiaux entre eux (18a) réalisés sur les extrémités dudit anneau en C et indiqués pour recevoir une vis de fermeture qui peut être actionnée par l'opérateur.

6. Élément radiant à fluide (4) selon la revendication 5), **caractérisé en ce que** ladite vis est une vis autotaraudeuse.

7. Élément radiant à fluide (4) selon la revendication 1), **caractérisé en ce que** lesdits moyens de logement consistent en un ou plusieurs sièges prismatiques (21) chacun de ceux-ci étant encastré dans ledit corps collecteur (12) et ayant son profil interne s'accouplant au profil externe de l'interrupteur à état solide correspondant (2).

8. Élément radiant à fluide (4) selon la revendication 7), **caractérisé en ce qu'**il comprend des moyens de blocage dudit interrupteur à état solide (2) à l'intérieur du siège prismatique correspondant (21).
